(19)

Europäisches
Patentamt
European
Patent Office
Office européen
des brevets

(11) **EP 2 626 443 A1**

(12) **EUROPEAN PATENT APPLICATION**
published in accordance with Art. 153(4) EPC

(43) Date of publication:
**14.08.2013 Bulletin 2013/33**

(21) Application number: **11830700.8**

(22) Date of filing: **05.10.2011**

(51) Int Cl.:
**C23C 14/34** (2006.01)   **B22F 3/115** (2006.01)
**B22F 3/15** (2006.01)   **B22F 3/24** (2006.01)
**C22C 1/02** (2006.01)   **C22C 1/04** (2006.01)
**C22C 21/00** (2006.01)   **C22F 1/00** (2006.01)

(86) International application number:
**PCT/JP2011/072980**

(87) International publication number:
**WO 2012/046768 (12.04.2012 Gazette 2012/15)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.04.2011 JP 2011086696
08.10.2010 JP 2010228983**

(71) Applicants:
• **Kabushiki Kaisha Kobe Seiko Sho
Chuo-ku
Kobe-shi
Hyogo 651-8585 (JP)**
• **Kobelco Research Institute , Inc.
Kobe-shi
Hyogo 651-0073 (JP)**

(72) Inventors:
• **MATSUMOTO, Katsushi
Hyogo 6512271 (JP)**
• **TAKAGI, Katsutoshi
Hyogo 6768670 (JP)**
• **TAKETOMI, Yuichi
Hyogo 6768670 (JP)**
• **NAKAI, Junichi
Hyogo 6768670 (JP)**
• **MAKINO, Hidetada
Hyogo 6768670 (JP)**
• **TAKAGI, Toshiaki
Hyogo 6768670 (JP)**

(74) Representative: **Hoffmanns, Ulrich
Müller-Boré & Partner
Grafinger Straße 2
DE-81671 München (DE)**

(54) **AL-BASED ALLOY SPUTTERING TARGET AND PRODUCTION METHOD OF SAME**

(57) There is provided an Al-based alloy sputtering target, which can provide an enhanced deposition rate (or sputtering rate) when the sputtering target is used, and which can preferably prevent the occurrence of splashes. The Al-based alloy sputtering target of the present invention includes Ta and may preferably include an Al-Ta-based intermetallic compound containing Al and Ta, which compound has a mean particle diameter of from 0.005 $\mu$m to 1.0 $\mu$m and a mean interparticle distance of from 0.01 $\mu$m to 10.0 $\mu$m.

EP 2 626 443 A1

**Description**

TECHNICAL FIELD

The present invention relates to an Al-based alloy sputtering target and a production method of the same. More specifically, the present invention relates to an Al-based alloy sputtering target, which can provide an enhanced deposition rate (or sputtering rate) when the sputtering target is used, and which can preferably prevent the occurrence of splashes; and a production method of the same.

BACKGROUND ART

Al-based alloys have low electrical resistivity and are easy to undergo processing. For these reasons, Al-based alloys have widely been used in the fields of flat panel displays (FPDs) such as liquid crystal displays (LCDs), plasma display panels (PDPs), electroluminescent displays (ELDs), field emission displays (FEDs), and MEMS displays; touch panels; and electronic papers. For example, Al-based alloys have been used as the materials of interconnection films, electrode films, and reflective electrode films.

For the deposition of an Al-based alloy thin film, there has usually been employed a sputtering process using a sputtering target. The sputtering process means a method of depositing a thin film, in which a plasma discharge is induced between a substrate and a sputtering target made of the same material as that of the thin film, and a gas ionized by the plasma discharge is impinged on the sputtering target to beat some atoms out of the sputtering target, and these atoms are deposited on the substrate to thereby form the thin film.

In contrast to vacuum vapor deposition process, the sputtering process has a merit that a thin film can be deposited to have the same composition as that of the sputtering target. In particular, an Al-based alloy thin film deposited by the sputtering process can enable alloy elements such as neodymium (Nd) to be dissolved, which alloy elements do not dissolve in the equilibrium state, so that the Al-based alloy thin film exhibits excellent characteristics as a thin film. Therefore, the sputtering process is an industrially effective method of deposing a thin film, and a development is proceeding on a sputtering target that is a source of the thin film.

In recent years, the deposition rate (or sputtering rate) in the sputtering process has a tendency to be increased than before to meet an improvement in the productivity of FPDs. The deposition rate can most easily be increased by an increase in sputtering power. However, an increase in sputtering power causes the occurrence of sputtering failures such as splashes (i.e., fine molten particles) to form defects, for example, in the interconnection films, resulting in serious problems such as lowering in the yield and performance of FPDs.

Thus, for the purpose of enhancing the deposition rate, there have been proposed, for example, methods of Patent Documents 1 and 2. Among them, Patent Document 1 discloses a method of improving the deposition rate by controlling the content of (111) crystal orientation in the sputtering surface of an Al alloy target. On the other hand, Patent Document 2 discloses a method of improving the deposition rate by controlling the area ratio of <001>, <011>, <111>, and <311> crystal orientations in the sputtering surface of an Al-Ni-rare earth element alloy sputtering target.

PRIOR ART DOCUMENTS

PATENT DOCUMENTS

Patent Document 1: Japanese Patent Laid-open Publciation (Kokai) No. Hei 6-128737
Patent Document 2: Japanese Patent Laid-open Publication (Kokai) No. 2008-127623

SUMMARY OF THE INVENTION

PROBLEMS TO BE SOLVED BY THE INVENTION

As described above, various techniques have been proposed so far for the purpose of improving the deposition rate, but there is a need for further improvement.

The present invention has been made in view of the circumstances described above, an object of which invention is to provide an Al-based alloy sputtering target, which can provide an enhanced deposition rate when the sputtering target is used, and which can preferably prevent the occurrence of splashes; and a production method of the same.

MEANS FOR SOLVING THE PROBLEMS

The Al-based alloy sputtering target of the present invention, which can solve the problems described above, is characterized by comprising Ta.

In a preferred embodiment of the present invention, the Al-based alloy sputtering target may comprise an Al-Ta-based intermetallic compound containing Al and Ta, which compound has a mean particle diameter of from 0.005 $\mu$m to 1.0 $\mu$m and a mean interparticle distance of from 0.01 $\mu$m to 10.0 $\mu$m.

In a preferred embodiment of the present invention, the Al-based alloy sputtering target may have an oxygen content of from 0.01 atomic% to 0.2 atomic%.

In a preferred embodiment of the present invention, the Al-based alloy sputtering target may further comprise at least one element in at least one group selected from

a first group consisting of rare earth elements;
a second group consisting of Fe, Co, Ni, and Ge;
a third group consisting of Ti, Zr, Hf, V, Nb, Cr, Mo, and W; and
a fourth group consisting of Si and Mg.

In a preferred embodiment of the present invention, the Al-based alloy sputtering target may further comprise at least one element selected from the first group consisting of rare earth elements.

In a preferred embodiment of the present invention, the Al-based alloy sputtering target may further comprise at least one element selected from the second group consisting of Fe, Co, Ni, and Ge.

In a preferred embodiment of the present invention, the Al-based alloy sputtering target may further comprise at least one element selected from the third group consisting of Ti, Zr, Hf, V, Nb, Cr, Mo, and W.

In a preferred embodiment of the present invention, the Al-based alloy sputtering target may further comprise at least one element selected from the fourth group consisting of Si and Mg.

In a preferred embodiment of the present invention, the at least one element selected from the first group may be at least one element selected from the group consisting of Nd and La.

In a preferred embodiment of the present invention, the at least one element selected from the first group may be Nd.

In a preferred embodiment of the present invention, the at least one element selected from the second group may be at least one element selected from the group consisting of Ni and Ge.

In a preferred embodiment of the present invention, the at least one element selected from the third group may be at least one element selected from the group consisting of Ti, Zr, and Mo.

In a preferred embodiment of the present invention, the at least one element selected from the third group may be Zr.

In a preferred embodiment of the present invention, the at least one element selected from the fourth group may be Si.

In a preferred embodiment of the present invention, the Al-based alloy sputtering target may have a Vickers hardness (Hv) of 26 or higher.

The present invention further includes a production method of an Al-based alloy sputtering target as set forth above, the method comprising:

preparing an ingot of the alloy by spray forming; and
successively subjecting the alloy ingot to densification, forging, hot rolling, and annealing;
wherein the spray forming, hot rolling, and annealing are carried out under the following conditions:

melting temperature in the spray forming is in the range of from 700°C to 1400°C;
gas/metal ratio in the spray forming is 10 Nm$^3$/kg or lower;
starting temperature in the hot rolling is in the range of from 250°C to 500°C; and
annealing temperature after the hot rolling is in the range of from 200°C to 450°C.

Furthermore, after the annealing, cold rolling and annealing after the cold rolling may preferably be carried out under the following conditions:

rolling reduction in the cold rolling is in the range of from 5% to 40%;
annealing temperature after the cold rolling is in the range of from 150°C to 250°C; and
annealing time after the cold rolling is in the range of from 1 to 5 hours.

EFFECTS OF THE INVENTION

The Al-based alloy sputtering target of the present invention is as described above, and therefore, the use of a sputtering target as set forth above makes it possible to provide an enhanced deposition rate and preferably effectively prevent the occurrence of splashes.

MODE FOR CARRYING OUT THE INVENTION

The present inventors have intensively studied to provide an Al-based alloy sputtering target, which can provide an enhanced deposition rate when an Al-based alloy film is deposited using the sputtering target, and which can preferably prevent the occurrence of splashes. As a result, the present inventors have found that the use of an Al-based alloy sputtering target containing Ta is useful, and in particular, the appropriate control of the size (mean particle diameter; this means circle-equivalent diameter) and dispersion state (mean interparticle distance) of an Al-Ta-based intermetallic compound containing at least Al and Ta is extremely useful, for an improvement in deposition rate; and further that the Ta-containing sputtering target should be made to have a controlled Vickers hardness of 26 or higher to prevent the occurrence of splashes, thereby completing the present invention.

(Composition of Al-based alloy sputtering target)

First, the following will describe the composition of the Al-based alloy sputtering target of the present invention. As described above, the Al-based alloy sputtering target of the present invention contains Ta. According to the experimental results of the present inventors, it was confirmed that Ta is bound to Al to form Al-Ta-based intermetallic compounds, distributed in the Al matrix, thereby making a great contribution to an improvement in deposition rate during deposition. In addition, Ta is an element also useful for an improvement in the corrosion and heat resistance of an Al-based alloy film to be deposited using the sputtering target of the present invention.

To effectively exhibit such an action, the Al-based alloy sputtering target of the present invention may preferably contain Ta, for example, in a content of 0.01 atomic% or higher. The above action has a tendency to be more enhanced in a higher content of Ta. The upper limit of the Ta content is not particularly limited from the viewpoint of the above action. The amount of Al-Ta-based intermetallic compound is increased in a higher content of Ta. The Al-Ta-based intermetallic compound has a high melting point of 1500°C or higher. Therefore, taking productivity and producibility on an industrial scale into consideration, the upper limit of the Ta content may preferably be controlled approximately to 30.0 atomic%. The Ta content may more preferably be from 0.02 atomic% to 25.0 atomic%, still more preferably from 0.04 atomic% to 20.0 atomic%.

The Al-based alloy sputtering target of the present invention contains Ta, the remainder being Al and unavoidable impurities. The Al-based alloy sputtering target of the present invention may contain other elements described below for the purpose of further improving the above action or effectively exhibiting other actions than the above action.

(A) Oxygen

Oxygen is an element useful for a further improvement in the above action by allowing an Al-Ta-based intermetallic compound, which is useful for an improvement in deposition rate, to be finely dispersed (the details thereof will be described below). As described below, the Al-based alloy sputtering target of the present invention is recommended to be produced by spray forming, powder metallurgy, or any other process. The experiments of the present inventors revealed that the presence of oxygen in a prescribed content makes finely dispersed oxides become the deposition sites of an Al-Ta-based intermetallic compound, resulting in the further fine dispersion of the Al-Ta-based intermetallic compound to make a great contribution to an improvement in deposition rate. To effectively exhibit such an action, the Al-based alloy sputtering target of the present invention may preferably contain oxygen in a content of 0.01 atomic% or higher. In this regard, however, too high oxygen contents result in the formation of coarse oxides, thereby lowering the effect of making the Al-Ta-based intermetallic compound finely dispersed. Therefore, the upper limit of the oxygen content may preferably be set to 0.2 atomic%. More preferably, the oxygen content may be from 0.01 atomic% to 0.1 atomic%.

(B) Rare earth elements (first group elements)

Rare earth elements (first group elements) are elements effective for an improvement in the heat resistance of an Al-based alloy film to be deposited using the Al-based alloy sputtering target, thereby preventing the formation of hillocks on the surface of the Al-based alloy film. The rare earth element to be used in the present invention is included in the element group consisting of lanthanoid elements (fifteen (15) elements ranging from La of atomic number 57 to Lu of atomic number 71 in the Periodic Table) plus Sc and Y. Preferred rare earth elements (first group elements) are Nd and La, and a more preferred rare earth element (first group element) is Nd. These elements may be used alone or in combination.

To effectively exhibit the above action, the rare earth element content (which is a content of one rare earth element when this rare earth element is contained alone or which is a total content of two or more rare earth elements when these rare earth elements are contained in combination) may preferably be 0.05 atomic% or higher. The above action has a tendency to be improved in a higher rare earth element content. The addition of a rare earth element or elements in a too high content makes the electrical resistivity of the Al-based alloy film become higher. Therefore, the upper limit of the rare earth element content may preferably be set to 10.0 atomic%. More preferably, the rare earth element content may be from 0.1 atomic% to 5.0 atomic%.

(C) Fe, Co, Ni, and Ge (second group elements)

Fe, Co, Ni, and Ge (second group elements) are elements effective for a reduction in the contact electrical resistance between the Al-based alloy film and the pixel electrodes coming in direct contact with the Al-based alloy film, which elements further have a contribution to an improvement in heat resistance. Fe, Co, Ni, and Ge may be used alone or in combination. Preferred second group elements are at least one element selected from the group consisting of Ni and Ge.

To effectively exhibit the above action, the Fe, Co, Ni, and/or Ge content (which is a content of one second group element when this second group element is contained alone or which is a total content of two or more second group elements when these second group elements are contained in combination) may preferably be 0.05 atomic% or higher. The above action has a tendency to be improved in a higher second group element content. The addition of the second group element or elements in a too high content makes the electrical resistivity of the Al-based alloy film become higher. Therefore, the upper limit of the second group element content may preferably be set to 10.0 atomic%. More preferably, the second group element content may be from 0.1 atomic% to 5.0 atomic%.

(D) Ti, Zr, Hf, V, Nb, Cr, Mo, and W (third group elements)

Ti, Zr, Hf, V, Nb, Cr, Mo, and W (third group elements) are elements having a contribution to an improvement in the corrosion and hest resistance of the Al-based alloy film. These elements may be used alone or in combination. Preferred third group elements are at least one element selected from the group consisting of Ti, Zr, and Mo, and a more preferred third group element is Zr. In this regard, however, too high contents of third group elements result in an increase in the electrical resistivity of the Al-based alloy film. The Ti, Zr, Hf, V, Nb, Cr, Mo, and/or W content (which is a content of one third group element when this third group element is contained alone or which is a total content of two or more third group elements when these third group elements are contained in combination) may preferably be from 0.05 atomic% to 10.0 atomic%, more preferably from 0.1 atomic% to 5.0 atomic%.

(E) At least one element selected from the group consisting of Si and Mg (fourth group elements)

At least one element selected from the group consisting of Si and Mg is an element having a contribution to an improvement in the corrosion resistance, such as weather resistance, of the Al-based alloy film. These elements may be used alone or in combination. The fourth group element may preferably be Si. In this regard, however, too high contents of fourth group elements result in an increase in the electrical resistivity of the Al-based alloy film. The content of at least one element selected from the group consisting of Si and Mg (which content is a content of one fourth group element when this fourth group element is contained alone or which content is a total content of two fourth group elements when these fourth group elements are contained in combination) may preferably be from 0.05 atomic% to 10.0 atomic%, more preferably from 0.1 atomic% to 5.0 atomic%.

The Al-based alloy sputtering target of the present invention may preferably have a composition containing, as a component, Ta (and further oxygen in a recommended content), and further containing an element or elements in at least one group selected from:

the first group consisting of rare earth elements;
the second group consisting of Fe, Co, Ni, and Ge;
the third group consisting of Ti, Zr, Hf, V, Nb, Cr, Mo, and W; and
the fourth group consisting of Si and Mg.

As the targets having more preferred compositions, there can be mentioned the following (i) to (iv):

(i) Preferred are Al (which means an Al alloy containing elements indicated below, the remainder being Al and unavoidable impurities; the same holds true in the following)-Ta-O-first group element (rare earth element) sputtering targets as shown in Nos. 4 to 6 of Table 1 described below. More preferred are Al-Ta-O-Nd sputtering targets.

(ii) Preferred are Al-Ta-O-first group element (rare earth element)-second group element sputtering targets as shown in Nos. 7, 8, and 10 of Table 1 described below. More preferred are Al-Ta-O-(at least one element selected from the group consisting of Nd and La)-(at least one element selected from the group consisting of Ni and Ge) sputtering targets. Still more preferred are Al-Ta-O-Nd-(Ni and Ge) sputtering targets.

(iii) Preferred are Al-Ta-O-first group element (rare earth element)-second group element-third group element sputtering targets as shown in Nos. 17 to 30 of Table 2 described below. More preferred are Al-Ta-O-Nd-second group element-third group element sputtering targets. Still more preferred are Al-Ta-O-Nd-(at least one selected from the group consisting of Ni and Ge)-third group element sputtering targets. Further still more preferred are Al-Ta-O-Nd-(at least one selected from the group consisting of Ni and Ge)-Zr sputtering targets. Particularly preferred are Al-Ta-O-Nd-(Ni and Ge)-Zr sputtering targets as shown in No. 29 of Table 2 described below.

(iv) Preferred are Al-Ta-O-first group element (rare earth element)-second group element-third group element-fourth group element sputtering targets as shown in Nos. 34 to 37 of Table 2 described below. More preferred are Al-Ta-O-Nd-second group element-third group element-fourth group element sputtering targets. Still more preferred are Al-Ta-O-Nd-(at least one selected from the group consisting of Ni and Ge, particularly Ni and Ge)-third group element-fourth group element sputtering targets. Further still more preferred are Al-Ta-O-Nd-(at least one selected from the group consisting of Ni and Ge, particularly Ni and Ge)-Zr-fourth group element sputtering targets. Particularly preferred are Al-Ta-O-Nd-(Ni and Ge)-Zr-Si sputtering targets as shown in No. 34 of Table 2 described below.

Furthermore, as sputtering targets having other preferred compositions, there can be mentioned Al-Ta-O-second group element sputtering targets, Al-Ta-O-second group element-third group element sputtering targets, and Al-Ta-O-second group element-third group element-fourth group element sputtering targets.

(Size and dispersion state of Al-Ta-based intermetallic compound)

The following will describe the size and dispersion state of an Al-Ta-based intermetallic compound characterizing the present invention.

The Al-Ta-based intermetallic compound means a compound containing at least Al and Ta. The Al-Ta-based intermetallic compound may further contain other elements (e.g., preferred optional elements as described above) than Al and Ta described above, depending on the compositions and production conditions of Al-based alloy sputtering targets. The category of the Al-Ta-based intermetallic compound may include intermetallic compounds further containing such elements.

The present invention is characterized in that the Al-Ta-based intermetallic compound may have a mean particle diameter of from 0.005 $\mu$m to 1.0 $\mu$m and a mean interparticle distance of from 0.01 $\mu$m to 10.0 $\mu$m. The Al-based alloy sputtering targets meeting both of these conditions can provide high deposition rates as compared with pure Al sputtering targets (see Examples described below).

First, the Al-Ta-based intermetallic compound may have a mean particle diameter of from 0.005 $\mu$m to 1.0 $\mu$m. The present invention makes it possible to uniformly generate sputtering phenomenon by minimizing the mean particle diameter of Al-Ta-based intermetallic compound to a nano-order of 1.0 $\mu$m or smaller, resulting in an improvement in deposition rate. To effectively exhibit such an action, the Al-Ta-based intermetallic compound may preferably have as small a mean particle diameter as possible. However, taking producibility on an industrial scale into consideration, the lower limit of the mean particle diameter may approximately be about 0.005 $\mu$m. In this regard, the "mean particle diameter" means a mean circle-equivalent diameter when measured by the method described below, and the details thereof will be described below.

Furthermore, the Al-Ta-based intermetallic compound may have a mean interparticle distance of from 0.01 $\mu$m to 10.0 $\mu$m. The present invention makes it possible to provide uniform sputtering state on the sputtering surface by controlling the mean particle diameter as well as the mean interparticle distance to appropriately control the dispersion state of the Al-Ta-based intermetallic compound, resulting in a further improvement in deposition rate. To effectively exhibit such an action, the intermetallic compound may preferably have as small a mean interparticle distance as possible. However, taking producibility on an industrial scale into consideration, the lower limit of the mean interparticle distance may approximately be about 0.01 $\mu$m. In this regard, the measurement method of the "mean interparticle distance" will be described below.

The sputtering target of the present invention may contain an intermetallic compound meeting the composition and requirements described above. The sputtering target of the present invention may preferably have a Vickers hardness (Hv) of 26 or higher, which makes it possible to prevent the occurrence of splashes. The reasons why the occurrence of splashes can be prevented by making Vickers hardness high as described above is not known in detail, but it may be assumed as follows. That is, when the sputtering target has a low Vickers hardness, microscopic smoothness becomes worse on the finished surface in the machining process with a milling machine or lathe used in the production of the sputtering target. In other words, material surface causes complicated deformation and becomes coarse. Therefore, stains such as cutting oil used in the machining process are incorporated into the surface of the sputtering target and remains therein. Such stains are difficult to be sufficiently removed, even if the surface is cleaned in a later process. The stains remaining on the surface of the sputtering target seems to become the initial occurrence sites of splashes at the time of sputtering. Then, not to allow such stains to remain on the surface of the sputtering target, machining performance (sharpness) in the machining process should be improved not to make coarse material surface. For this reason, the present invention makes sputtering targets preferably have increased Vickers hardness.

The Al-based alloy sputtering target of the present invention may preferably have as high a Vickers hardness as possible from the viewpoint of preventing the occurrence of splashes, and may more preferably have, for example, a Vickers hardness of 35 or higher, still more preferably 40 or higher, and further still more preferably 45 or higher. In this regard, the upper limit of the Vickers hardness is not particularly limited. When the Vickers hardness is too high, the rolling reduction in the cold rolling for controlling the Vickers hardness should be increased, which makes it hard to carry out the rolling. Therefore, the Al-based alloy sputtering target of the present invention may preferably have a Vickers hardness of 160 or lower, more preferably 140 or lower, and still more preferably 120 or lower.

The Al-based alloy sputtering target of the present invention was explained as described above.

The following will provide an explanation of a method for producing the Al-based alloy sputtering target.

The Al-based alloy sputtering target of the present invention is recommended to be produced, for example, by preparing an ingot of the alloy having a prescribed composition by spray forming, powder metallurgy, or any other process, and then optionally subjecting the alloy ingot to densification such as hot isostatic pressing (HIP), followed by forging, hot rolling, and annealing. After these processes, cold rolling and annealing (i.e., the second-time process of rolling and annealing) may be carried out.

When an ingot of the alloy having a prescribed composition is prepared, spray forming may preferably be adopted, for example, from the viewpoint that the size and dispersion state of the Al-Ta-based intermetallic compound can easily be controlled. The "spray forming" as used herein means a method of preparing a material (preform) in a prescribed shape by blowing a high-pressure inert gas onto an Al alloy molten flow in a chamber under an inert gas atmosphere for atomization and depositing particles rapidly cooled in a semi-molten, semi-solidified, or solid phase state. The spray forming has been disclosed in many documents by the present applicant, for example, Japanese Patent Laid-open Publication (Kokai) Nos. Hei 9-248665, Hei 11-315373, 2005-82855, and 2007-247006, all of which are incorporated herein by reference. Furthermore, Patent Document 2 described above is also incorporated herein by reference.

More specifically, as the preferred spray forming conditions to prepare a desired Al-Ta-based intermetallic compound, there can be mentioned, for example, the melting temperature of from 700°C to 1400°C and the gas/metal ratio of 10 $Nm^3$/kg or lower, more preferably from 5 to 8 $Nm^3$/kg.

Furthermore, at least any of the hot rolling conditions (e.g., starting temperature, finishing temperature, maximum rolling reduction per pass, total rolling reduction) in the process after the preparation of an alloy ingot by spray forming or any other process may preferably be controlled in an appropriate manner to prepare a desired Al-Ta-based intermetallic compound. More specifically, the starting temperature for rolling and annealing temperature in these processes may be controlled in the range of from 250°C to 500°C and from 200°C to 450°C, respectively.

In the present invention, for the purpose of adjusting the Vickers hardness to the preferred level, it is recommended to control the rolling reduction in the range of approximately from 5% to 40% and the annealing conditions in the range of about 150°C to about 250°C and about 1 to about 5 hours when the second-time process of rolling and annealing is carried out.

EXAMPLES

The following will describe the present invention in detail by way of Examples, but the present invention is not limited to the Examples described below. The present invention can be put into practice after appropriate modifications or variations within a range capable of meeting the gist described above and below, all of which are included in the technical scope of the present invention.

(Example 1)

Ingots of alloys having the compositions shown in Table 1 were prepared by (1) spray forming or (2) powder metallurgy. The detailed production conditions for each process are as described below.

(1) Spray forming

First, Al-based alloy preforms shown in Table 1 were prepared under the spray forming conditions described below.
(Spray forming conditions)
Melting temperature: 1300°C
Atomizing gas: nitrogen gas
Gas/metal ratio: 7 Nm$^3$/kg
Spray distance: 1050 mm
Gas atomizing outlet angel: 1°
Collector angle: 35°

Then, the preforms thus prepared were each sealed in a capsule for degassing, and densified with an HIP apparatus. The HIP treatment was carried out under the following conditions: HIP temperature, 550°C; HIP pressure, 85 MPa; and HIP time, 2 hours.

The Al-based alloy densified samples thus prepared were each forged under the following conditions: heating temperature before forging, 500°C; heating time, 2 hours; and upset ratio per forging, 10% or lower, thereby giving a slab (size: thickness, 60 mm; width, 540 mm; and length, 540 mm).

Then, the slabs were each subjected to rolling (conditions: starting temperature for rolling, 400°C; and total rolling reduction, 85%) and annealing (conditions: 200°C and 4 hours), followed by machining process, thereby giving an Al-based alloy plate (thickness, 8 mm; width, 150 mm; and length, 150 mm).

Then, the Al-based alloy plates were each subjected to round blanking process and lathe process, thereby giving a disk-shaped sputtering target of 4 inch in diameter (and 5 mm in thickness).

(2) Powder metallurgy

In the powder metallurgy, pure Al powder of 100 mesh and powder materials of the respective elements were put into a V-mixer and mixed for 45 minutes.

Then, the mixtures were each subjected to HIP treatment, heating before forging, forging, rolling, annealing, round blanking process, and lathe process, in the same manner as in the spray forming described in (1) above, thereby giving a disk-shaped sputtering target of 4 inch in diameter (and 5 mm in thickness).

For comparison, No. 11 (pure Al of 4N purity) shown in Table 1 was produced by melting process. More specifically, an ingot of 100 mm in thickness was prepared by DC casting process and then soaking was performed at 400°C for 4 hours, followed by rolling process at room temperature at the rolling reduction of 75%. Thereafter, the sample was heat treated at 200°C for 4 hours and rolled at room temperature at the rolling reduction of 40%.

Various sputtering target materials thus prepared were measured for the size (mean particle diameter; this means circle-equivalent diameter) and dispersion state (mean interparticle distance) of the Al-Ta-based intermetallic compound by microscopic observation and image processing as described below. More specifically, the types of microscopes were changed depending on the size (circle equivalent diameter) of the Al-Ta-based intermetallic compound observed in a field of view, and the size and dispersion state of the Al-Ta-based intermetallic compound were calculated by the methods described in (3) and (4) below. The mean values calculated from these values were regarded as the mean particle diameter and mean interparticle distance of Al-Ta-based intermetallic compound.

(3) Measurement of mean particle diameter and mean interparticle distance when circle equivalent diameter of Al-Ta-based intermetallic compound is greater than 1 μm

In this case, the compound was observed with an FE-SEM (of magnification 1000 times).
First, a sample for measurement was prepared as follows. The sputtering targets were each cut to give measurement surfaces (i.e., surfaces parallel to the rolling direction among cross-sectional surfaces perpendicular to the rolled surface; more specifically, surface part, 1/4 x t part, and 1/2 x t part for thickness "t" of the sputtering target). Then, the measurement surfaces were made smooth by polishing with, for example, emery paper or diamond paste, thereby giving a sample for FE-SEM measurement.

Then, the sample for measurement thus prepared was photographed for five fields of view (one field of view was about 80 μm long by about 100 μm wide) at each of three sites in total, i.e., surface part, 1/4 x t part, and 1/2 x t part, along the plate thickness direction of the sputtering target with an FE-SEM (of magnification 1000 times). At that time, the intermetallic compounds were each analyzed by EDS to extract the intermetallic compound showing the detection of Ta peak. Then, the intermetallic compound showing the detection of Ta peak in each of the photographs was considered as the Al-Ta-based intermetallic compound containing at least Al and Ta, which compound was quantitatively analyzed by image processing to determine the circle equivalent diameter for every photograph, the mean value of which was regarded as the "mean particle diameter of Al-Ta-based intermetallic compound."

Furthermore, the number density of the compound considered as the Al-Ta-based compound (two dimensional, the number of pieces per unit area) was determined for every photograph, the mean value of which was calculated to determine the mean interparticle distance of Al-Ta-based intermetallic compound by the following conversion formula:

$$\text{Mean interparticle distance of Al-Ta-based compound}$$

$$= 2 \times \{\, 1 \div \pi \div [\text{number density (two dimensional)}]\,\}^{1/2}$$

(4) Measurement of mean particle diameter and mean interparticle distance when circle equivalent diameter of Al-Ta-based intermetallic compound is 1 $\mu$m or smaller

In this case, the compound was observed with a TEM (of magnification 7500 times).
First, a sample for measurement was prepared as follows. A sample of about 0.8 mm in thickness was cut out from each of the measurement surfaces (i.e., surfaces parallel to the rolling direction among cross-sectional surfaces perpendicular to the rolled surface; more specifically, surface part, 1/4 x t part, and 1/2 x t part for thickness "t" of the sputtering target) of the above sputtering targets. Then, each sample was polished to a thickness of about 0.1 mm with, for example, emery paper or diamond paste, from which a disk of 3 mm in diameter was punched out and subjected to electrolytic etching with Struers Tenupol-5 using 30% nitric acid-methanol solution as an electrolytic solution, thereby giving a sample for TEM observation.
Then, the sample for measurement thus prepared was photographed for five fields of view (one field of view was about 10 $\mu$m long by about 14 $\mu$m wide) at each of three sites in total, i.e., surface part, 1/4 x t part, and 1/2 x t part, along the plate thickness direction of the sputtering target with a TEM (of magnification 7500 times). At that time, the intermetallic compounds were each analyzed by EDS to extract the intermetallic compound showing the detection of Ta peak. Then, the intermetallic compound showing the detection of Ta peak in each of the photographs was considered as the Al-Ta-based intermetallic compound containing at least Al and Ta, which compound was quantitatively analyzed by image processing to determine the circle equivalent diameter for every photograph, the mean values of which was regarded as the "mean particle diameter of Al-Ta-based intermetallic compound."
Furthermore, the number density of the compound considered as the Al-Ta-based compound (three dimensional, the number of pieces per unit volume) was determined for every photograph, the mean value of which was calculated to determine the mean interparticle distance of Al-Ta-based intermetallic compound by the following conversion formula:

$$\text{Mean interparticle distance of Al-Ta-based compound}$$

$$= 2 \times \{\, (3/4) \div \pi \div [\text{number density (three dimensional)}]\,\}^{1/3}$$

In this regard, the number density (three dimensional) of the compound was calculated for every photograph using a volume obtained by multiplying the area of the field of view (one field of view was about 10 $\mu$m long by about 14 $\mu$m wide) with the thickness of a TEM sample at the site of observation, which thickness was measured in the TEM by the contamination spot method.
In the present invention, the size and dispersion state of the Al-Ta-based intermetallic compound were calculated by the methods described in (3) and (4) above, the mean values of which were regarded as the mean particle diameter and mean interparticle distance of Al-Ta-based intermetallic compound. In the present invention, the sputtering targets were considered as passing when the mean particle diameter and mean interparticle distance of Al-Ta-based intermetallic compound thus calculated were in the range of from 0.005 $\mu$m to 1.0 $\mu$m and in the range of from 0.01 $\mu$m to 10.0 $\mu$m, respectively.

(5) Measurement of Vickers hardness of sputtering targets

Furthermore, various sputtering targets described above were measured for Vickers hardness (Hv) using a Vickers hardness tester ("AVK-G2" available from Akashi Seisakusho) under a load of 50 g. In the Examples, the sputtering targets were considered as passing when the Vickers hardness was 26 or higher.

(6) Regarding the number of the occurrence of splashes

Sputtering was carried out using each of the sputtering targets under the following conditions to give a thickness of approximately 600 nm, at which time the degree of the occurrence of splashes was observed.
More specifically, first, DC magnetron sputtering was carried out on a glass substrate (size: 4 inch in diameter and 0.70 mm in thickness) named "EAGLE XG" available from Corning Incorporated using a sputtering apparatus named "Sputtering System HSR-542S" available from Shimadzu Corporation so that the film thickness became approximately 600 nm. The sputtering conditions were as follows:

Degree of vacuum reached: 7 x 10$^{-6}$ Torr
Ar gas pressure: 2 mTorr
Discharge electric power: 260 W
Ar gas flow rate: 30 sccm
Interelectrode distance: 50 nm
Substrate temperature: room temperature
Deposition time (sputtering time): 240 seconds

Then, the position coordinates, size (mean particle diameter), and number of particles observed on the surface of the thin film were measured using a particle counter (wafer surface inspection apparatus "WM-3" available from Topcon Corporation), in which particles of 3 $\mu$m or greater in size were regarded as the "particles." Thereafter, the surface of this thin film was observed with an optical microscope (of magnification 1000 times), in which particles in hemisphere shape were regarded as splashes and the number of splashes per unit area was measured.

In Example 1, the sputtering targets were evaluated as "A" or "B" when the number of the occurrence of splashes thus measured was not greater than 10 pieces/cm$^2$ or not smaller than 11 pieces/cm$^2$, respectively. In this Example, the sputtering targets evaluated as "A" were considered as passing (exhibiting the splash reduction effect).

(7) Measurement of deposition rate ratio to pure Al

The thin film deposited by the method described in (6) above was measured for thickness with a stylus step gauge ("Alpha-Step 250" available from Tencor Instruments). The measurement of thickness was carried out at three sites in total taken in an interval of 5 mm from the center of the thin film toward the radius direction of the thin film, the mean value of which was regarded as the "thin film thickness" (nm). The "thin film thickness" thus measured was divided by sputtering time (sec) for the calculation of mean deposition rate (nm/sec).

For comparison, the deposition rate ratio to pure Al (= mean deposition rate of each thin film / mean deposition rate of pure Al) was calculated, in which the mean deposition rate obtained when a thin film was deposited in the same manner as described above using pure Al of 4N purity (No. 11 in Table 1) was used as a standard. Higher deposition rate ratios to pure Al thus calculated mean higher deposition rates.

In Example 1, the sputtering targets were evaluated as "A" or "B" when the deposition rate ratio to pure Al was not lower than 1.1 or lower than 1.1, respectively. In this Example, the sputtering targets evaluated as "A" were considered as passing (providing high deposition rate).

These results are shown together in Table 1. In Table 1, the term "S/F" indicates examples using spray forming. Furthermore, the item "overall rating" is provided in the rightmost column of Table 1, in which the symbols "A" and "B" indicate examples meeting all the requirements of the present invention and examples not meeting any of the requirements defined in the present invention, respectively.

[Table 1]

| No. | Composition (the units are all atomic% and the remainder is Al and unavoidable impurities) | | | | | | | Preparation method | Mean particle diameter of Al-Ta-based intermetallic compound ($\mu$m) | Mean interparticle distance of Al-Ta-based intermetallic compound ($\mu$m) | Vickers hardness | Deposition rate ratio to pure Al | Number of occurrence of splashes (pieces/cm$^2$) | Overall rating |
|---|---|---|---|---|---|---|---|---|---|---|---|---|---|---|
| | Ta | Nd | La | Ni | Ge | Ti | Oxygen | | | | | | | |
| 1 | 0.04 | - | - | - | - | - | 0.036 | S/F | 0.12 | 0.24 | 34 | 1.24 | 7 | A |
| 2 | 0.10 | - | - | - | - | - | 0.044 | S/F | 0.19 | 0.22 | 36 | 1.31 | 9 | A |
| 3 | 1.50 | - | - | - | - | - | 0.036 | S/F | 0.41 | 0.16 | 41 | 1.61 | 6 | A |
| 4 | 2.00 | 4.00 | - | - | - | - | 0.020 | S/F | 0.52 | 0.12 | 44 | 1.92 | 5 | A |
| 5 | 2.00 | 4.00 | - | - | - | - | 0.084 | powder metallurgy | 0.54 | 0.15 | 40 | 1.75 | 5 | A |
| 6 | 0.16 | 0.28 | - | - | - | | 0.029 | S/F | 0.22 | 0.21 | 38 | 1.38 | 8 | A |
| 7 | 0.50 | - | 2.00 | 1.00 | 1.5 | - | 0.025 | S/F | 0.43 | 0.16 | 41 | 1.58 | 7 | A |
| 8 | 0.50 | - | 2.00 | 0.10 | 0.5 | - | 0.024 | S/F | 0.41 | 0.18 | 39 | 1.58 | 8 | A |
| 9 | - | - | - | - | - | 2.0 | 0.028 | S/F | 0.63 | 0.17 | 36 | 1.04 | 8 | B |
| 10 | 0.50 | 0.27 | - | 0.10 | 0.5 | - | 0.030 | S/F | 0.32 | 0.22 | 38 | 1.41 | 6 | A |
| 11 | - | - | - | - | - | - | 0.002 | Melting process | - | - | 23 | 1.00 | 26 | B |
| 12 | - | 0.20 | - | - | - | - | 0.020 | S/F | 0.12 | 0.31 | 26 | 0.98 | 8 | B |

* No. 11: pure Al of 4N purity

As can be seen from Table 1, Nos. 1 to 8 and 10 contained Ta and had respective mean particle diameters and mean interparticle distances of Al-Ta-based intermetallic compound, all of which met the preferred requirements of the present invention, and therefore, these sputtering targets provided deposition rates higher than that of pure Al. Furthermore, these sputtering targets had respective Vickers hardness values controlled in the preferred range, thereby making it possible to sufficiently reduce the occurrence of splashes.

In contrast to this, Nos. 9 and 12 containing no Ta merely provided respective deposition rates in approximately the same level as that of No. 11 (pure Al of 4N purity). Furthermore, No. 11 had the Vickers hardness value lower than the preferred range, and therefore, the occurrence of splashes became increased.

(Example 2)

Ingots of alloys having the compositions shown in Table 2 were prepared by (1) spray forming or (2) powder metallurgy under the same conditions as described in Example 1. In the case where (1) spray forming was adopted, each of the Al-based alloy preforms thus prepared was densified with an HIP apparatus in the same manner as described in Example 1, followed by forging, rolling, and annealing, and then, followed by round blanking process and lathe process, thereby giving a disk-shaped sputtering target of 4 inch in diameter (and 5 mm in thickness). Furthermore, in the case where (2) powder metallurgy was adopted, powders were mixed with one another in the same manner as described in Example 1, and then densified with an HIP apparatus in the same manner as the case of spray forming described above, followed by forging, rolling, and annealing, and then, followed by round blanking process and lathe process, thereby giving a disk-shaped sputtering target of 4 inch in diameter (and 5 mm in thickness).

The sputtering targets thus produced were measured for the mean particle diameter and mean interparticle distance of Al-Ta-based intermetallic compound in the same manner as described in Example 1. In the present invention, the sputtering targets were considered as passing when the mean particle diameter and mean interparticle distance of Al-Ta-based intermetallic compound thus measured were in the range of from 0.005 $\mu$m to 1.0 $\mu$m and in the range of from 0.01 $\mu$m to 10.0 $\mu$m, respectively.

Furthermore, various sputtering targets described above were measured for Vickers hardness (Hv) in the same manner as described in Example 1. In the present invention, the sputtering targets were considered as passing when the Vickers hardness thus measured was 26 or higher.

Furthermore, various sputtering targets described above were measured for the number of the occurrence of splashes in the same manner as in Example 1. In Example 2, the sputtering targets were evaluated as "A" (considered as passing; and exhibiting the splash reduction effect) or "B" (considered as not passing; and not exhibiting the splash reduction effect) when the number of the occurrence of splashes thus measured was not greater than 10 pieces/cm$^2$ or not smaller than 11 pieces/cm$^2$, respectively.

Furthermore, with respect to various sputtering targets described above, deposition rate ratios to pure Al were calculated in the same manner as described in Example 1. In Example 2, the sputtering targets were evaluated as "A" (considered as passing; and providing high deposition rate) or "B" (considered as not passing; and providing low deposition rate) when the deposition rate ratio to pure Al thus calculated was not lower than 1.1 or lower than 1.1, respectively.

These results are shown together in Table 2. In Table 2, the term "S/F" indicates examples using spray forming. Furthermore, the item "overall rating" is provided in the rightmost column of Table 2, in which the letters "A" and "B" indicate examples meeting all the requirements of the present invention and examples not meeting at least one of the requirements defined in the present invention, respectively.

EP 2 626 443 A1

[Table 2]

| No. | Composition (the units are all atomic% and the remainder is Al and unavoidable impurities) | | | | | | | | | | | | | | Preparation method | Characteristics of sputtering targets | | | | | |
|---|---|---|---|---|---|---|---|---|---|---|---|---|---|---|---|---|---|---|---|---|---|
| | Ta | Nd | La | Fe | Co | Ni | Ge | Ti | Zr | Mo | W | Si | Mg | Oxygen | | Mean particle diameter of Al·Ta ·based intermetallic compound (μm) | Mean interparticle distance of Al·Ta ·based intermetallic compound (μm) | Vickers hardness | Deposition rate ratio to pure Al | Number of occurrence of splashes (pieces/cm²) | Overall rating |
| 13 | 1.0 | – | – | – | – | – | 1.0 | 0.5 | – | – | – | – | – | 0.024 | S/F | 0.40 | 0.19 | 38 | 1.68 | 7 | A |
| 14 | 1.0 | – | – | – | – | – | 1.0 | – | 0.5 | – | – | – | – | 0.028 | S/F | 0.42 | 0.17 | 40 | 1.63 | 6 | A |
| 15 | 1.0 | – | – | – | – | – | 1.0 | – | – | 0.5 | – | – | – | 0.076 | powder metallurgy | 0.39 | 0.14 | 39 | 1.48 | 7 | A |
| 16 | 1.0 | – | – | – | – | – | 1.0 | – | – | – | 0.5 | – | – | 0.070 | powder metallurgy | 0.37 | 0.15 | 38 | 1.49 | 7 | A |
| 17 | 0.5 | 2.0 | – | – | – | – | 0.5 | 0.3 | – | – | – | – | – | 0.046 | S/F | 0.32 | 0.20 | 41 | 1.57 | 5 | A |
| 18 | 0.5 | – | 2.0 | – | – | – | 0.5 | 0.3 | – | – | – | – | – | 0.043 | S/F | 0.30 | 0.21 | 40 | 1.56 | 6 | A |
| 19 | 0.45 | 0.2 | – | – | – | – | 0.5 | – | 0.4 | – | – | – | – | 0.033 | S/F | 0.28 | 0.18 | 38 | 1.45 | 7 | A |
| 20 | 0.45 | – | 0.2 | – | – | – | 0.5 | – | 0.4 | – | – | – | – | 0.030 | S/F | 0.27 | 0.17 | 37 | 1.41 | 8 | A |
| 21 | 0.45 | 0.2 | – | – | – | – | 0.5 | – | – | 0.4 | – | – | – | 0.082 | powder metallurgy | 0.22 | 0.12 | 37 | 1.23 | 8 | A |
| 22 | 0.45 | – | 0.2 | – | – | – | 0.5 | – | – | 0.4 | – | – | – | 0.078 | powder metallurgy | 0.22 | 0.13 | 37 | 1.25 | 8 | A |
| 23 | 0.45 | 0.2 | – | – | – | – | 0.5 | – | – | – | 0.4 | – | – | 0.085 | powder metallurgy | 0.24 | 0.11 | 38 | 1.23 | 7 | A |
| 24 | 0.45 | – | 0.2 | – | – | – | 0.5 | – | – | – | 0.4 | – | – | 0.080 | powder metallurgy | 0.25 | 0.13 | 37 | 1.29 | 8 | A |
| 25 | 0.45 | 0.2 | – | 0.1 | – | – | 0.5 | – | 0.35 | – | – | – | – | 0.077 | powder metallurgy | 0.24 | 0.14 | 35 | 1.30 | 9 | A |
| 26 | 0.45 | – | 0.2 | 0.1 | – | – | 0.5 | – | 0.35 | – | – | – | – | 0.069 | powder metallurgy | 0.26 | 0.15 | 34 | 1.34 | 9 | A |
| 27 | 0.45 | 0.2 | – | – | 0.1 | – | 0.5 | – | 0.35 | – | – | – | – | 0.029 | S/F | 0.29 | 0.18 | 35 | 1.46 | 9 | A |
| 28 | 0.45 | – | 0.2 | – | 0.1 | – | 0.5 | – | 0.35 | – | – | – | – | 0.021 | S/F | 0.27 | 0.21 | 35 | 1.50 | 9 | A |
| 29 | 0.45 | 0.2 | – | – | – | 0.1 | 0.5 | – | 0.35 | – | – | – | – | 0.026 | S/F | 0.28 | 0.20 | 37 | 1.50 | 8 | A |
| 30 | 0.45 | – | 0.2 | – | – | 0.1 | 0.5 | – | 0.35 | – | – | – | – | 0.025 | S/F | 0.28 | 0.20 | 36 | 1.50 | 8 | A |
| 31 | 0.5 | – | – | 1.0 | – | – | 0.5 | – | 0.4 | – | – | – | – | 0.076 | powder metallurgy | 0.25 | 0.14 | 38 | 1.31 | 7 | A |
| 32 | 0.5 | – | – | – | 1.0 | – | 0.5 | – | 0.4 | – | – | – | – | 0.030 | S/F | 0.29 | 0.18 | 38 | 1.46 | 7 | A |
| 33 | 0.5 | – | – | – | – | 1.0 | 0.5 | – | 0.4 | – | – | – | – | 0.025 | S/F | 0.31 | 0.19 | 39 | 1.52 | 7 | A |
| 34 | 0.4 | 0.3 | – | – | – | – | 0.5 | 0.5 | 0.35 | – | – | 0.2 | – | 0.041 | S/F | 0.27 | 0.21 | 40 | 1.50 | 6 | A |
| 35 | 0.4 | 0.3 | – | – | – | – | 0.5 | 0.5 | 0.35 | – | – | – | 0.2 | 0.038 | S/F | 0.29 | 0.22 | 40 | 1.57 | 6 | A |
| 36 | 0.4 | – | 0.3 | – | – | 0.5 | 0.5 | – | 0.35 | – | – | 0.2 | – | 0.044 | S/F | 0.29 | 0.19 | 39 | 1.49 | 7 | A |
| 37 | 0.4 | – | 0.3 | – | – | 0.5 | 0.5 | – | 0.35 | – | – | – | 0.2 | 0.047 | S/F | 0.26 | 0.19 | 39 | 1.44 | 7 | A |

As can be seen from Table 2, Nos. 13 to 37 contained Ta and had respective mean particle diameters and mean interparticle distances of Al-Ta-based intermetallic compound, all of which met the preferred requirements of the present invention, and therefore, these sputtering targets provided deposition rates higher than that of pure Al. Furthermore, these sputtering targets had respective Vickers hardness values controlled in the preferred range, thereby making it possible to sufficiently reduce the occurrence of splashes.

(Example 3)

Disk-shaped sputtering targets of 4 inch in diameter (and 5 mm in thickness) having the composition of Al-0.45 atomic% Ta-0.026 atomic% 0-0.2 atomic% Nd-0.1 atomic% Ni-0.5 atomic% Ge-0.35 atomic% Zr (i.e., the same composition as that of No. 29 shown in Table 2) were produced in the same manner as described in Example 1 (the alloy ingot was prepared by (1) spray forming as described above), except that the conditions (melting temperature in spray forming, gas/metal ratio in spray forming, starting temperature in hot rolling, and annealing temperature after hot rolling) shown in Table 3 were employed.

With respect to various sputtering targets thus produced, the mean particle diameters and mean interparticle distances of the Al-Ta-based intermetallic compound were calculated in the same manner as described Example 1. The sputtering targets were considered as passing when the mean particle diameter and mean interparticle distance of Al-Ta-based intermetallic compound thus calculated were in the range of from 0.005 $\mu$m to 1.0 $\mu$m and in the range of from 0.01 $\mu$m to 10.0 $\mu$m, respectively.

Furthermore, with respect to various sputtering targets described above, deposition rate ratios to pure Al were calculated in the same manner as described in Example 1. These results are shown together in Table 3.

[Table 3]

| No. | Production conditions | | | | Characteristics of sputtering targets | | |
|---|---|---|---|---|---|---|---|
| | Melting temperature in spray forming (°C) | Gas/ metal ratio in spray forming (Nm$^3$/kg) | Starting temperature in hot rolling (°c) | Annealing temperature after hot rolling (°C) | Meanparticle diameter of Al-Ta-based intermetallic compound ($\mu$m) | Mean interparticle distance of Al-Ta-based intermetallic compound ($\mu$m) | Deposition rate ratio to pure Al |
| 29 | 1300 | 7 | 400 | 200 | 0.28 | 0.20 | 1.50 |
| 38 | 1400 | 7 | 400 | 200 | 0.41 | 0.35 | 1.27 |
| 39 | 1500 | 7 | 400 | 200 | 1.2 | 15.3 | 1.04 |
| 40 | 1300 | 10 | 400 | 200 | 0.38 | 0.31 | 1.31 |
| 41 | 1300 | 13 | 400 | 200 | 1.5 | 13.6 | 1.01 |
| 42 | 1300 | 7 | 250 | 200 | 0.20 | 0.25 | 1.44 |
| 43 | 1300 | 7 | 500 | 200 | 0.29 | 0.28 | 1.40 |
| 44 | 1300 | 7 | 550 | 200 | 1.4 | 14.2 | 1.02 |
| 45 | 1300 | 7 | 400 | 450 | 0.31 | 0.29 | 1.34 |
| 46 | 1300 | 7 | 400 | 550 | 1.3 | 14.7 | 1.03 |

The following discussion can be made from Table 3. That is, in any of Nos. 29, 38, 40, 42, 43, and 45, the melting temperature in the spray forming, gas/metal ratio in the spray forming, starting temperature in the hot rolling, and annealing temperature after the hot rolling met the preferred requirements of the present invention, so that these sputtering targets had respective mean particle diameters and mean interparticle distances of Al-Ta-based intermetallic compound, all of which were controlled in the preferred range, and therefore, these sputtering targets provided deposition rates higher than that of pure Al.

In contrast to this, in any of Nos. 39, 41, 44, and 46, at least one of the melting temperature in the spray forming, gas/metal ratio in the spray forming, starting temperature in the hot rolling, and annealing temperature after the hot rolling did not meet the preferred requirements of the present invention, so that these sputtering targets had respective mean particle diameters and mean interparticle distances of Al-Ta-based intermetallic compound, all of which are not controlled in the preferred range, and therefore, these sputtering targets merely provided deposition rates in approximately the same level as that of pure Al.

(Example 4)

Disk-shaped sputtering targets of 4 inch in diameter (and 5 mm in thickness) having the composition of Al-0.16 atomic% Ta-0.029 atomic% O-0.28 atomic% Nd (i.e., the same composition as that of No. 6 shown in Table 1) were produced in the same manner as described in Example 1 (the alloy ingot was prepared by (1) spray forming as described above), except that cold rolling and annealing after the cold rolling were carried out under the conditions (rolling reduction in the cold rolling, annealing temperature after the cold rolling, and annealing time after the cold rolling) shown in Table 4, subsequently to the annealing after the hot rolling.

Various sputtering targets thus produced were measured for Vickers hardness (Hv) in the same manner as described in Example 1. The sputtering targets were considered as passing when the Vickers hardness thus measured was 26 or higher.

Furthermore, various sputtering targets described above were measured for the number of the occurrence of splashes in the same manner as described in Example 1. In Example 4, the sputtering targets were evaluated as "A" (exhibiting the splash reduction effect) when the number of the occurrence of splashes thus measured was 10 pieces/cm$^2$ or smaller. These results are shown together in Table 4.

[Table 4]

| No. | Production conditions | | | Characteristics of sputtering targets | | |
|---|---|---|---|---|---|---|
| | Rolling reduction in cold rolling | Annealing temperature after coldrolling | Annealing time after cold rolling | Vickers hardness | Number of occurrence of splashes | |
| | (%) | (°C) | (hours) | | (pieces/cm$^2$) | Rating |
| 47 | 2 | 200 | 4 | 24 | 16 | - |
| 48 | 5 | 200 | 4 | 34 | 9 | A |
| 49 | 40 | 200 | 4 | 38 | 8 | A |
| 50 | 40 | 150 | 4 | 38 | 8 | A |
| 51 | 40 | 250 | 4 | 36 | 8 | A |
| 52 | 40 | 350 | 4 | 23 | 23 | - |
| 53 | 40 | 200 | 1 | 39 | 7 | A |
| 54 | 40 | 200 | 5 | 37 | 8 | A |
| 55 | 40 | 200 | 7 | 23 | 20 | - |

The following discussion can be made as follows. That is, in any of Nos. 48 to 51, 53, and 54, the rolling reduction in the cold rolling, the annealing temperature after the cold rolling, and the annealing time after the cold rolling met the preferred requirements of the present invention, so that these sputtering targets had respective Vickers hardness values, all of which were controlled in the preferred range, and therefore, these sputtering targets sufficiently reduced the occurrence of splashes. In contrast to this, in any of Nos. 47, 52, and 55, at least one of the rolling reduction in the cold rolling, the annealing temperature after the cold rolling, and the annealing time after the cold rolling did not meet the preferred requirements of the present invention, so that these sputtering targets had respective Vickers hardness values, all of which are not controlled in the preferred range, and therefore, these sputtering targets were not able to sufficiently reduce the occurrence of splashes.

(Example 5)

Disk-shaped sputtering targets of 4 inch in diameter (and 5 mm in thickness) having the compositions of groups I to IV shown in Table 5 were produced in the same manner as described in Example 1 (the alloy ingots were prepared by (1) spray forming as described above). Using various Al-based alloy sputtering targets thus produced, various Al-based alloy thin films were deposited as follows.

DC magnetron sputtering was carried out on a glass substrate (size: 4 inch in diameter and 0.70 mm in thickness) named "EAGLE XG" available from Corning Incorporated using a sputtering apparatus named "Sputtering System HSR-542S" available from Shimadzu Corporation so that the film thickness became approximately 300 nm. The sputtering conditions were as follows:

Degree of vacuum reached: 7 x $10^{-6}$ Torr
Ar gas pressure: 2 mTorr
Discharge electric power: 260 W
Ar gas flow rate: 30 sccm
Interelectrode distance: 50 mm
Substrate temperature: room temperature
Deposition time (sputtering time): 120 seconds

Various Al-based alloy thin films thus deposited were heat treated by being kept at a temperature of 550°C for 20 minutes under an inert gas ($N_2$) atmosphere and then measured for electrical resistivity by the direct current four probe method. Group I, in which low electrical resistivity was valued more than high heat resistance as the characteristics of thin films, were considered as "A" (extremely low) when the electrical resistivity was 4 $\mu\Omega$-cam or lower, "B" (low) when the electrical resistivity was higher than 4 $\mu\Omega$-cm but 8 $\mu\Omega$-cm or lower, or "C" (not low) when the electrical resistivity was higher than 8 $\mu\Omega$-cm. Groups II to IV, in which high heat resistance was valued more than low electrical resistivity as the characteristics of thin films, were considered as "A" (extremely low) when the electrical resistivity was 6 $\mu\Omega$-cm or lower, "B" (low) when the electrical resistivity was higher than 6$\mu$ $\Omega$-cm but 12 $\mu\Omega$-cm or lower, or "C" (not low) when the electrical resistivity was higher than 12 $\mu\Omega$-cm. These results are shown together in Table 5.

[Table 5]

| Group | No. | Compositions of Al-based alloy sputtering targets | Characteristics of thin films |
|-------|-----|---------------------------------------------------|-------------------------------|
|       |     |                                                   | Electrical resistivity        |
| I | 6 | Al-0.16 atomic% Ta-0.029 atomic% O-0.28 atomic% Nd | A |
|   | 56 | Al-0.16 atomic% Ta-0.029 atomic% O-0.28 atomic% La | B |
| II | 10 | Al-0.50 atomic% Ta-0.030 atomic% O-0.27 atomic% Nd-0.10 atomic% Ni-0.5 atomic% Ge | A |
|    | 58 | Al-0.50 atomic% Ta-0.030 atomic% O-0.27 atomic% Nd-0.10 atomic% Co-0.5 atomic% Ge | B |
| III | 29 | Al-0.45 atomic% Ta-0.026 atomic% O-0.2 atomic% Nd-0.1 atomic% Ni-0.5 atomic% Ge-0.35 atomic% Zr | A |
|     | 59 | Al-0.45 atomic% Ta-0.026 atomic% O-0.2 atomic% Nd-0.1 atomic% Ni-0.5 atomic% Ge-0.35 atomic% Ti | B |
|     | 60 | Al-0.45 atomic% Ta-0.026 atomic% O-0.2 atomic% Nd-0.1 atomic% Ni-0.5 atomic% Ge-0.35 atomic% Mo | B |
|     | 61 | Al-0.45 atomic% Ta-0.026 atomic% O-0.2 atomic% Nd-0.1 atomic% Ni-0.5 atomic% Ge-0.35 atomic% W | B |
| IV | 34 | Al-0.4 atomic% Ta-0.041 atomic% O-0.3 atomic% Nd-0.5 atomic% Ni-0.5 atomic% Ge-0.35 atomic% Zr-0.2 atomic% Si | A |
|    | 35 | Al-0.4 atomic% Ta-0.041 atomic% O-0.3 atomic% Nd-0.5 atomic% Ni-0.5 atomic% Ge-0.35 atomic% Zr-0.2 atomic% Mg | B |

The following discussion can be made from Table 5. That is, Nos. 6, 10, 29, and 34 are examples using the sputtering targets having particularly preferred compositions among the Al-based alloy sputtering targets of the present invention. From a comparison of No. 6 with No. 56, it can be found that thin films containing Nd as the first group element (rare earth element) have lower electrical resistivity than that of, and therefore, are superior to, thin films containing La as the first group element (rare earth element). In addition, from a comparison of No. 10 with No. 58, it can be found that thin films containing a combination of Ni and Ge as the second group elements have lower electrical resistivity than that of, and therefore, are superior to, thin films containing a combination of Co and Ge as the second group elements. In addition, from a comparison of No. 29 with Nos. 59 to 61, it can be found that thin films containing Zr as the third group element have lower electrical resistivity than that of, and therefore, are superior to, thin films containing Ti, Mo, or W as the third group element. Furthermore, from a comparison of No. 34 with No. 35, it can be said that thin films containing Si as the fourth group element have lower electrical resistivity than that of, and therefore, are superior to, thin films containing Mg as the fourth group element.

**Claims**

1. An Al-based alloy sputtering target comprising Ta.

2. The Al-based alloy sputtering target according to claim 1, comprising an Al-Ta-based intermetallic compound containing Al and Ta, which compound has a mean particle diameter of from 0.005 $\mu$m to 1.0 $\mu$m and a mean interparticle distance of from 0.01 $\mu$m to 10.0 $\mu$m.

3. The Al-based alloy sputtering target according to claim 2, having an oxygen content of from 0.01 atomic% to 0.2 atomic%.

4. The Al-based alloy sputtering target according to any one of claims 1 to 3, further comprising at least one element in at least one group selected from:

   a first group consisting of rare earth elements;
   a second group consisting of Fe, Co, Ni, and Ge;
   a third group consisting of Ti, Zr, Hf, V, Nb, Cr, Mo, and W; and
   a fourth group consisting of Si and Mg.

5. The Al-based alloy sputtering target according to claim 3, further comprising at least one element selected from a first group consisting of rare earth elements.

6. The Al-based alloy sputtering target according to claim 3, further comprising at least one element selected from a second group consisting of Fe, Co, Ni, and Ge.

7. The Al-based alloy sputtering target according to claim 5, further comprising at least one element selected from a second group consisting of Fe, Co, Ni, and Ge.

8. The Al-based alloy sputtering target according to claim 6, further comprising at least one element selected from a third group consisting of Ti, Zr, Hf, V, Nb, Cr, Mo, and W.

9. The Al-based alloy sputtering target according to claim 7, further comprising at least one element selected from a third group consisting of Ti, Zr, Hf, V, Nb, Cr, Mo, and W.

10. The Al-based alloy sputtering target according to claim 8, further comprising at least one element selected from a fourth group consisting of Si and Mg.

11. The Al-based alloy sputtering target according to claim 9, further comprising at least one element selected from a fourth group consisting of Si and Mg.

12. The Al-based alloy sputtering target according to claim 5, wherein the at least one element selected from the first group is at least one element selected from the group consisting of Nd and La.

13. The Al-based alloy sputtering target according to claim 5, wherein the at least one element selected from the first group is Nd.

14. The Al-based alloy sputtering target according to claim 7, wherein the at least one element selected from the second group is at least one element selected from Ni and Ge.

**15.** The Al-based alloy sputtering target according to claim 9, wherein the at least one element selected from the third group is at least one element selected from Ti, Zr, and Mo.

**16.** The Al-based alloy sputtering target according to claim 9, wherein the at least one element selected from the third group is Zr.

**17.** The Al-based alloy sputtering target according to claim 11, wherein the at least one element selected from the fourth group is Si.

**18.** The Al-based alloy sputtering target according to claim 1, having a Vickers hardness (Hv) of 26 or higher.

**19.** A method for producing an Al-based alloy sputtering target as set forth in claim 1, comprising:

preparing an ingot of the alloy by spray forming; and
successively subjecting the alloy ingot to densification, forging, hot rolling, and annealing;

wherein the spray forming, hot rolling, and annealing are carried out under the following conditions:

melting temperature in the spray forming is in the range of from 700°C to 1400°C;
gas/metal ratio in the spray forming is 10 $Nm^3$/kg or lower;
starting temperature in the hot rolling is in the range of from 250°C to 500°C; and
annealing temperature after the hot rolling is in the range of from 200°C to 450°C.

**20.** The production method according to claim 19, further comprising:

cold rolling after the annealing; and
annealing after the cold rolling;

wherein the cold rolling and the annealing after the cold rolling are carried out under the following conditions:

rolling reduction in the cold rolling is in the range of from 5% to 40%;
annealing temperature after the cold rolling is in the range of from 150°C to 250°C; and
annealing time after the cold rolling is in the range of from 1 to 5 hours.

<div align="center">

**INTERNATIONAL SEARCH REPORT**

</div>

| | International application No. |
|---|---|
| | PCT/JP2011/072980 |

**A. CLASSIFICATION OF SUBJECT MATTER**
*C23C14/34*(2006.01)i, *B22F3/115*(2006.01)i, *B22F3/15*(2006.01)i, *B22F3/24*
(2006.01)i, *C22C1/02*(2006.01)i, *C22C1/04*(2006.01)i, *C22C21/00*(2006.01)i,
*C22F1/00*(2006.01)n
According to International Patent Classification (IPC) or to both national classification and IPC

**B. FIELDS SEARCHED**

Minimum documentation searched (classification system followed by classification symbols)
C23C14/34, B22F3/115, B22F3/15, B22F3/24, C22C1/02, C22C1/04, C22C21/00,
C22F1/00

Documentation searched other than minimum documentation to the extent that such documents are included in the fields searched
Jitsuyo Shinan Koho          1922-1996     Jitsuyo Shinan Toroku Koho     1996-2011
Kokai Jitsuyo Shinan Koho     1971-2011     Toroku Jitsuyo Shinan Koho     1994-2011

Electronic data base consulted during the international search (name of data base and, where practicable, search terms used)
JSTPlus(JDreamII)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 9-248665 A  (Kobe Steel, Ltd.),<br>22 September 1997 (22.09.1997),<br>claims; paragraphs [0024], [0028], [0029],<br>[0035], [0036], [0041]; table 1<br>(Family: none) | 1,4<br>2,3,8,9,<br>15-20 |
| X<br>Y | WO 99/34028 A1  (Toshiba Corp.),<br>08 July 1999 (08.07.1999),<br>claim 1; page 17, lines 21 to 24; page 19,<br>lines 8 to 22; table 5<br>& US 6736947 B1 | 1,2,4<br>3,5-20 |
| X<br>Y | JP 11-293454 A  (Hitachi Metals, Ltd.),<br>26 October 1999 (26.10.1999),<br>claims; paragraphs [0028], [0031], [0038];<br>tables 1, 2<br>(Family: none) | 1,2,4<br>3,5-16 |

☒  Further documents are listed in the continuation of Box C.          ☐  See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>    28 October, 2011 (28.10.11) | Date of mailing of the international search report<br>    08 November, 2011 (08.11.11) |
|---|---|
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2011/072980

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 10-199830 A (Hitachi Metals, Ltd.),<br>31 July 1998 (31.07.1998),<br>claims; paragraphs [0022], [0023], [0026],<br>[0030]; tables 1, 3<br>(Family: none) | 1,4<br>5-9,12-16 |
| X<br>Y | JP 6-299354 A (Kobe Steel, Ltd.),<br>25 October 1994 (25.10.1994),<br>claims; paragraphs [0018] to [0020], [0024];<br>table 1<br>(Family: none) | 1<br>2,3 |
| X | JP 8-64554 A (Mitsubishi Materials Corp.),<br>08 March 1996 (08.03.1996),<br>claim 1; table 1<br>(Family: none) | 1 |
| Y | JP 2008-127623 A (Kobelco Research Institute,<br>Inc.),<br>05 June 2008 (05.06.2008),<br>claim 3; paragraphs [0065], [0073], [0074] to<br>[0085]; table 1<br>& EP 1932940 A1 | 18-20 |
| Y | JP 2009-263768 A (Kobelco Research Institute,<br>Inc.),<br>12 November 2009 (12.11.2009),<br>claims; paragraphs [0037], [0041], [0060],<br>[0061], [0068], [0069]; tables 1 to 7<br>& US 2009/0242394 A1 | 19-20 |
| Y | JP 2007-247006 A (Kobelco Research Institute,<br>Inc.),<br>27 September 2007 (27.09.2007),<br>claim 6; paragraphs [0043], [0051], [0054],<br>[0077]<br>(Family: none) | 19-20 |
| A | Seiji NISHI et al., "Technology in the<br>production of Sputtering Targets by the Melting<br>Method", Current advances in materials and<br>processes, 2002, vol.15, no.5, 968-971 | 1-20 |

Form PCT/ISA/210 (continuation of second sheet) (July 2009)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI6128737 B
- JP 2008127623 A
- JP HEI9248665 B
- JP HEI11315373 B
- JP 2005082855 A
- JP 2007247006 A